# EUROPEAN PATENT APPLICATION

(11) **EP 3 741 645 A1**
(43) Date of publication of application: **25.11.2020**
(21) Application number: 20174968.6
(22) Date of filing: 15.05.2020
(51) Int. Cl.: B61L 29/24, B61L 29/28

(54) **SOUND COMPENSATION FOR A RAILWAY WARNING SYSTEM**

(30) Priority: 16.05.2019 SE 1950583
(71) Applicant: Industrispår Svenska AB, 271 39 Ystad (SE)
(72) Inventor: Andersson, Gert, 271 51 Ystad (SE); Carlberg, Fredrik, 226 49 Lund (SE); Backman, Rasmus, 211 20 Malmö (SE)
(74) Representative: Hansson Thyresson AB

(57) **Abstract**

A sound compensation device (1) for a railroad crossing warning system (15) is provided, the device (1) comprising a water and dust resistant housing, and a sound recording device and a microprocessor arranged within the housing (2). The sound recording device is configured to register sound which originates from outside the housing and the microprocessor is configured to process the registered sound in order to emulate the sound perceived by a human ear outside the housing. The housing further comprises a valve which is sound transmissive and water and dust resistant. Thus, sound may be recorded within the housing, while the electronics are protected from e.g. dust and water.

## Description

### TECHNICAL FIELD

The present invention relates to a sound compensation device for a railroad crossing warning system, a railroad warning system comprising the sound compensation device, use of the device and a method for adjusting a sound level of a railroad warning system.

### BACKGROUND

Railways are an efficient and environmentally friendly way of travelling and transporting goods. With increased velocities, the railroads have been even more beneficial. However, with increased velocities, the dangers associated with railroads have also increased. Even though flyover crossings are increasing, especially in and around larger cities, many railroad crossings are still level crossings, which expose passing vehicles and pedestrians for danger. It is very important in these cases to have functional and suitable warning signals. These signals may be e.g. sound or light signals.

However, the railbound traffic operates around the clock, and these signals may expose nearby residents for disturbing noise.

From the above it is understood that there is room for improvements and the invention aims to solve or at least mitigate the above and other problems.

### SUMMARY

An object of the present invention is to provide a new type of railway crossing warning system which is improved over prior art and which eliminates or at least mitigates the drawbacks discussed above. More specifically, an object of the invention is to provide a sound compensation device for a railway crossing warning system and a method for registering sound within the sound compensation device and processing it to mimic ambient sound. These objects are achieved by the technique set forth in the appended independent claims with preferred embodiments defined in the dependent claims related thereto.

In a first aspect, a sound compensation device for a railroad crossing warning system is provided. The device comprises a water and dust resistant housing, and a sound recording device and a microprocessor arranged within the housing. The sound recording device is configured to register sound which originates from outside the housing, and the microprocessor is configured to process the registered sound in order to emulate the sound perceived by a human ear outside the housing. The housing further comprises a membrane which is sound transmissive and water and dust resistant. This is a beneficial device for registering ambient sound, while the sound registering device is arranged within a housing which protects it from the surrounding environment. Without the housing, the is a risk of the sound registering device being damaged by e.g. rain, dust or the like. But, a completely tight housing would not let enough sound through to be registered by the sound recording device. Therefore, the housing is provided with an efficient membrane, which allows sound, but not water or dust, to pass therethrough.

In one embodiment, the sound recording device is encapsulated by the housing. The sound recording device is preferably a microphone. Complete encapsulation of the sound recording device/microphone allows it to be protected from the environment.

In one embodiment, the membrane comprises a multilayer material. This is efficient in preventing dust and water to pass through the membrane. Each layer of the multilayer material has its own especially designed ability to stop a predetermined harmful contaminant, while at the same time let sound through.

Preferably, the multilayer material is Gore-Tex. This material has the advantages of allowing sound to pass through, but not e.g. dust or water.

The housing may comprise aluminum. This is a durable, lightweight and easily accessible material, suitable for a housing.

Preferably, the housing is IP65 rated. This means that the inner of the housing is protected against dust and water, which is favourable when electronic equipment is arranged in an outdoor environment.

In a second aspect, a railroad warning system is provided. The system comprises at least one sound emitting device and a sound compensation device. This system has the advantage of being able to adapt the sound level of the sound emitting device according to the ambient sound level after evaluation of the ambient sound level by means of the sound compensation device. Thus, nearby residents do not need to be disturbed by an unnecessary loud sound signal.

The railroad warning system may further comprise at least one of: one or more crossing gate(s) and one or more light signal(s). This provides additional safety to the railway crossing.

In a third aspect, use of the sound compensation device in a railroad crossing warning system is provided.

In a fourth aspect, a method for adjusting a sound level of a railroad warning system is provided. The method comprises the steps of:
- registering an ambient sound level by means of the sound recording device;
- processing the registered sound level to obtain a compensated sound level which correspond to a sound level of ambient sound perceivable by a human ear;
- comparing the compensated sound level with predetermined threshold level(s) corresponding to predetermined sound levels of the sound emitting device;
- adjusting the sound level of the sound emitting device correspondingly.
Advantages of this method is e.g. the ability to adapt the sound level of the sound emitting device according to the ambient sound level after evaluation of the ambient sound level by means of the sound compensation device. Thus, nearby residents do not need to be disturbed by an unnecessary loud sound signal.

### BRIEF DESCRIPTION OF THE DRAWINGS

Embodiments of the invention will be described in the following; references being made to the appended diagrammatical drawings which illustrate non-limiting examples of how the inventive concept can be reduced into practice.
Fig. 1 is a perspective view of a railway crossing;
Fig. 2 is a schematic view of a sound measurement and adjustment device and the components arranged therein;
Fig. 3 is a perspective view of the sound measurement and adjustment device; and
Fig. 4 is a flowchart of a sound adjustment process.

### DETAILED DESCRIPTION

Hereinafter, certain embodiments will be described more fully with reference to the accompanying drawings. The invention may, however, be embodied in many different forms and should not be construed as limited to the embodiments set forth herein; rather, these embodiments are provided by way of example so that this disclosure will be thorough and complete, and will fully convey the scope of the invention, such as it is defined in the appended claims, to those skilled in the art. If nothing else is stated, different embodiments may be combined with each other.

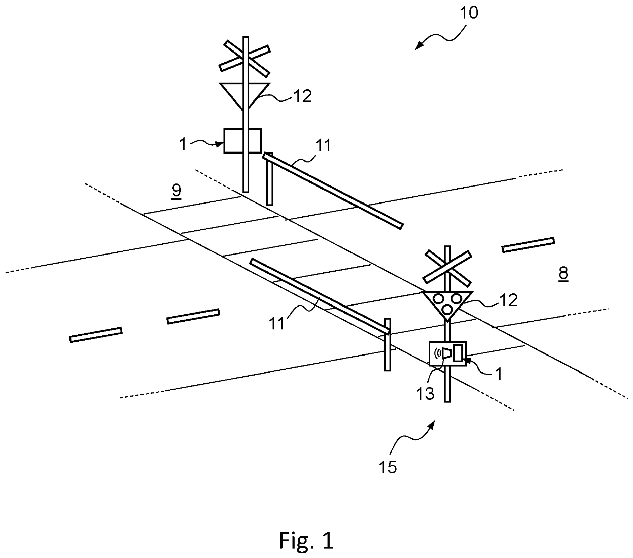

Fig. 1 shows a railway crossing 10 where a road 8 crosses a railway 9. In order to make road users aware of the fact that a train or other rail bound vehicle is approaching a railroad warning system 15 is arranged at the crossing 10. The warning system 15 comprises crossing gates 11, light signals 12 and a sound emitting device/sound signal/loudspeaker 13. Conventional additional parts of the railroad warning system 15 may comprise sensors, CPU's, and associated software. These are not further described in this text, as they are known to the person skilled in the art.

When a train is approaching the crossing the crossing gates 11 are configured to be lowered, the light signal 12 is configured to flash with e.g. a red light signal and the sound signal 13 is configured to toll. When the train has passed the crossing 10, the crossing gates 11 are raised, the light signal 12 ceases to flash, or it flashes with another colour of light, e.g. white light, and the sound signal 13 ceases to toll.

The tolling sound of the sound signal 13 may however be perceived as disturbing to nearby residents. To obtain a railroad crossing 10 which is safe, and at the same time not inconvenient, or even disturbing, for nearby residents, the railroad warning system 15 is provided with an adaptive sound signal 13. If the crossing 10 is situated in an urban area, with a lot of traffic or other noises, the volume of the signal 13 is automatically increased. Oppositely, if the crossing 10 is located in a rural area, the volume of the sound signal 13 is automatically decreased. In the same manner, the volume of the signal may be adjusted due to different background noise scenarios, e.g. on morning, night or daytime.

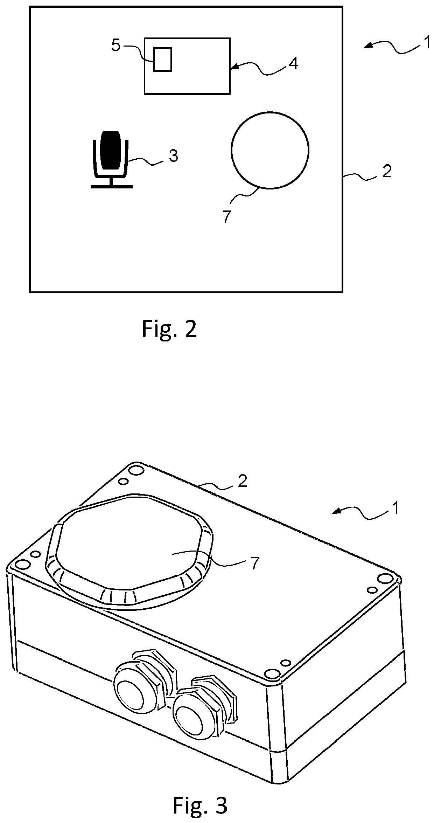

The railroad warning system 15 is provided with a sound compensation device 1, also denoted as sound measurement and adjustment device, which is shown in Figs 2-3. The device 1 comprises a housing or enclosure 2, preferably made of aluminum. The housing 2 is provided with a membrane 7, also denoted as valve or vent, to be further explained below. A sound registering device in the form of a digital microphone 3 and associated electronics 4 is arranged within the housing 2. The electronics comprises e.g. a microprocessor 5, and filters, e.g. in the form of one or more of an equalizer, a noise reducer, a gain control, or any other suitable process or filter or the like.

In order to protect the microphone 3 and the electronics 4, and since the lifetime of the device 2 needs to be long, and preferably no maintenance required, the housing 2 is made with an IP65-rating. Thus, the device 1 is dust- and watertight.

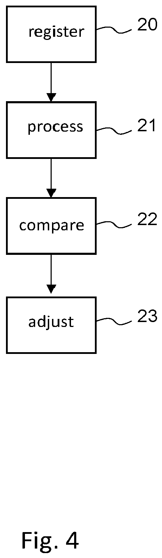

Referring to the flowchart in Fig. 4, in a first step 20, the digital microphone 3 is configured to pick up/register sound from the surroundings or ambient environment. The sound is converted to a digital signal to be processed and evaluated by the microprocessor 5. In a second step 21, the device 1 is configured to filter and process the registered sound signal to simulate the sound level perceived by the human ear. The processor 5 is configured to use one or more of the following methods: equalizer, noise reduction, A-weighted measurement method (dBA), C-weighted measurement method (dBC), or any other suitable measurement or filtering method. One example of processing made by the microprocessor 5 is compensation for sound frequencies which are blocked by the membrane 7. By identifying which frequencies are filtered out by the plug 7, they can be compensated for by using a combination of the above mentioned processing methods.

In a third step 22, the processed sound level signal is compared to a chart of one or several predetermined sound level threshold values. Each threshold value corresponds to a predetermined transmission sound level value. Thus, depending on the value of the processed sound level, the sound level of the loudspeaker or bell 13 is adjusted in a fourth step 23, and the loudspeaker 13 transmits the tolling sound at the predetermined sound level corresponding to a transmission sound level. The absolute values of the chart of threshold values and transmission sound level values may vary between different applications.

As described above, if the sound was recorded by a microphone arranged in a closed aluminum box, it would not correspond with the sound perceived by a human, who is located in the ambient environment outside the box, and it would be hard to compensate for the differences of the registered sound compared to the original sound. Thus, the sound must be registered in a way making it possible to process it in order to mimic the sound as a human would perceive it, in spite of the fact that the microphone 3 is encapsulated in the housing 2. Therefore, a valve or membrane 7 is provided in the housing 2. The membrane 7 comprises a multilayer structure which allows sound to pass through. However, the multilayer structure of the membrane 7 is still water and dust resistant, which means that the housing 2 is still IP65 rated. In the depicted embodiment, the multilayer structure of the membrane 7 comprises ePTFE, also known as Gore-Tex. This is a favourable material since it is sound-permeable but not water or dust permeable. It is also durable and endures a harsh environment which occurs at a railway crossing 10.

## Claims

1. A sound compensation device (1) for a railroad crossing warning system (15), the device (1) comprising:
a water and dust resistant housing (2), and
a sound recording device (3) and a microprocessor (5) arranged within the housing (2),
wherein the sound recording device (3) is configured to register sound which originates from outside the housing (2), and wherein the microprocessor (5) is configured to process the registered sound in order to emulate the ambient sound level, wherein the housing (2) further comprises a membrane (7) which is sound transmissive and water and dust resistant.

2. The device according to claim 1, wherein the sound recording device (3) is encapsulated by the housing (2), and preferably wherein the sound recording device (3) is a microphone.

3. The device according to claim 1 or 2, wherein the membrane (7) comprises a multilayer material.

4. The device according to claim 3, wherein the multilayer material is Gore-Tex.

5. The device according to any one of the preceding claims, wherein the housing (2) comprises aluminum, and preferably wherein the housing (2) is IP65 rated.

6. A railroad warning system comprising at least one sound emitting device (13) and a sound compensation device (1) according to any one of the claims 1-5.

7. The railroad warning system according to claim 6, further comprising at least one of: one or more crossing gate(s) (11) and one or more light signal(s) (12).

8. Use of the device according to any one of the claims 1-5 in a railroad crossing warning system (15).

9. Method for adjusting a sound level of a railroad warning system (15) according to claims 6-7 comprising the steps of:
- registering (20) an ambient sound level by means of the sound recording device (3);
- processing (21) the registered sound level to obtain a compensated sound level which correspond to a sound level of ambient sound;
- comparing (22) the compensated sound level with predetermined threshold level(s) corresponding to predetermined sound levels of the sound emitting device (13);
- adjusting (23) the sound level of the sound emitting device (13) correspondingly.
